# EUROPEAN PATENT APPLICATION

(11) **EP 2 485 261 A2**
(43) Date of publication of application: **08.08.2012**
(21) Application number: 12151742.9
(22) Date of filing: 19.01.2012
(51) Int. Cl.: H01L 27/146

(54) **Radiation detector and method for manufacturing the same**

(30) Priority: 07.02.2011 KR 20110010426
(71) Applicant: Samsung Electronics Co., Ltd., Suwon-si, Gyeonggi-do 442-742 (KR)
(72) Inventor: Kim, Eung Bum, Gyeonggi-do (KR)
(74) Representative: Grootscholten, Johannes A.M.

(57) **Abstract**

Disclosed herein is a radiation detector including a photosensor (3) and a capacitor (13). The radiation detector includes a plurality of photosensors having front (4) and rear electrodes (5) formed on front and rear surfaces thereof, an insulation layer (8) formed on the rear surfaces of the photosensors, a plurality of data electrodes (9) formed on the rear surface of the insulation layer, a plurality of signal electrodes (7) formed on the front surfaces of the photosensors, and the capacitor formed including the rear electrode formed on the rear surface of the photosensor, the insulation layer formed on the rear surfaces of the rear electrodes, and the data electrodes formed on the rear surface of the insulation layer.

## Description

### BACKGROUND OF THE INVENTION

### 1. Field of the Invention

The present invention relate to a radiation detector capable of generating images of the inside of a subject body by detecting x-rays.

### 2. Description of the Related Art

An X-ray apparatus may be used to diagnose a disease without dissecting a body of an animal or a patient by applying x-rays to the body, detecting the x-rays having passed through the body, and processing the detected x-rays so as to obtain images of the inside of the body.

The x-rays used for imaging are a highly penetrative form of electromagnetic radiation that have been emitted from an object when high speed electrons collide with the object. In general, an x-ray tube for generating x-rays includes a filament for generating thermoelectrons and electrodes for forming a strong electric field upon the application to the electrodes of a high voltage. The high voltage is generated by a high voltage supply which is applied to the x-ray tube so as to result in emission of thermoelectrons from the filament which forms a cathode portion of the x-ray tube. The emitted thermoelectrons are caused to drift under the influence of the strong electric field, and collide at an anode portion of the x-ray tube. At a local spot on the anode where the thermoelectrons collide, a x-rays are generated.

An x-ray detector detects an amount of the x-rays which pass through (or penetrate) the object when the x-rays are generated as described above. The detector is part of an imaging apparatus used to show images of the inside of the object as a result of detecting the penetration amount of the x-rays.

In general, an x-ray detector includes a thin film transistor array substrate and a photosensor. However, there is a problem in that leakage current may be generated during driving of the thin film transistor which results in noise during signal output.

Further, there is a problem in that an aperture ratio of the x-ray detector substrate is reduced due to an area of the thin film transistor occupying the pixel region, that is, an area receiving the x-rays is reduced. Such a problem increases as pixel size decreases.

### SUMMARY OF THE INVENTION

In general, the present invention provides a radiation detector including a photosensor and a capacitor.

Additional aspects of the invention will be set forth in the description which follows and, in part, will be obvious from the description, or may be learned by practice of the invention.

In accordance with one aspect of the present invention, a radiation detector includes a plurality of photosensors having front and rear electrodes formed on front and rear surfaces thereof, an insulation layer formed on the rear surface of the photosensors, a plurality of data electrodes formed on the rear surface of the insulation layer, a plurality of signal electrodes formed on the front surface of the photosensors, and a capacitor comprising the rear electrode formed on the rear surface of the photosensor, the insulation layer formed on the rear surface of the rear electrode, and the data electrode formed on the rear surface of the insulation layer.

The data electrode may induce an electrical signal in response to an electrical signal generated from the photosensor.

The signal electrode may apply voltage to the plurality of photosensors.

The signal electrode and the data electrode may be arranged to cross each other in a substantially perpendicular manner.

The front electrode of the photosensor may be a transparent electrode.

The front electrode may be made of any one of indium tin oxide (ITO) or indium zinc oxide (IZO).

The photosensor may be any one of a PIN photodiode or a PN photodiode.

The radiation detector may further include a scintillator formed on the front surface of the front electrode of the photosensor that converts radiation applied to the radiation detector into visible light.

The radiation detector may further include a protective layer, which is an insulating layer, formed so as to surround the photosensor.

The protective layer may be made of a material selected from a group including silicon oxide, silicon nitride, silicon oxynitride, benzocyclobutene, and polyamide.

In accordance with another aspect of the present invention, a radiation detector includes a plurality of photosensors having front and rear electrodes formed on front and rear surfaces thereof, a plurality of data electrodes formed on the rear surface of the photosensors, an insulation layer formed on the front surface of the photosensors, a plurality of capacitor electrodes formed on the front surface of the insulation layer, a plurality of signal electrodes formed on the front surface of the plurality of capacitor electrodes, and a capacitor comprising the front electrode formed on the front surface of the photosensor, the insulation layer formed on the front surface of the front electrode, and the capacitor electrode formed on the front surface of the insulation layer.

The data electrode may receive an electrical signal generated from the photosensor.

The signal electrode may apply voltage to the plurality of capacitor electrodes.

The signal electrode and the data electrode may be arranged to cross each other.

The front electrode of the photosensor may be a transparent electrode.

The front electrode may be made of any one selected from indium tin oxide (ITO) or indium zinc oxide (IZO).

The photosensor may be any one of a PIN photodiode or a PN photodiode.

The radiation detector may further include a scintillator formed on the front surface of the capacitor electrode that converts radiation applied to the radiation detector into visible light.

The radiation detector may further include a protective layer, which is an insulating layer, to surround the photosensor.

The protective layer may be made of a material selected from a group including silicon oxide, silicon nitride, silicon oxynitride, benzocyclobutene, and polyamide.

In accordance with another aspect of the present invention, a method for manufacturing a radiation detector includes forming a plurality of data electrodes on a substrate, forming an insulation layer on the front surface of the data electrode, forming a plurality of photosensors having front and rear electrodes formed on front and rear surfaces thereof on the front surface of the insulation layer, and forming a capacitor including the rear electrode, the insulation layer, and the data electrode.

In accordance with another aspect of the present invention, a method for manufacturing a radiation detector includes forming a plurality of data electrodes on a substrate, forming a plurality of photosensors having front and rear electrodes formed on front and rear surfaces thereof on the front surface of the data electrode, forming an insulation layer on the front surface of the photosensor, forming a plurality of capacitor electrodes on the front surface of the insulation layer, and forming a capacitor including the capacitor electrode, the insulation layer, and the front electrode.

In accordance with another aspect of the present invention, an X-ray image processing system is provided which incorporates a radiation detector according to one or more of the illustrated embodiments

The radiation detector according to one aspect of the present invention may reduce noise by solving the problem of current leakage generated when using a thin film transistor.

Further, the radiation detector according to one aspect of the present invention may increase an aperture ratio by eliminating the thin film transistor.

### BRIEF DESCRIPTION OF THE DRAWINGS

These and/or other aspects of the invention will become apparent and more readily appreciated from the following description of the embodiments, taken in conjunction with the accompanying drawings of which:
FIG. 1 is a schematic cross-sectional view showing a radiation detector according to one embodiment of the present invention;
FIG. 2 is a front/top view showing a radiation detector according to an embodiment of the present invention which may have a cross-section as shown in FIG. 1;
FIG. 3 is a schematic cross-sectional view showing a radiation detector according to another embodiment of the present invention;
FIGS. 4A through 4C are schematic views which illustrate the operation of a radiation detector according to one embodiment of the present invention, such as the detector shown in FIG. 1; and
FIG. 5 illustrates the basic components of a typical X-ray image processing system, modified, however, so as to incorporate a radiation detector constructed according to one or more of the FIG 2 or FIG. 3 embodiments.

### DETAILED DESCRIPTION OF THE INVENTION

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. Also, descriptions of well-known functions and constructions are omitted for clarity and conciseness.

Throughout the drawings, like reference numerals will be understood to refer to like parts, components and structures.

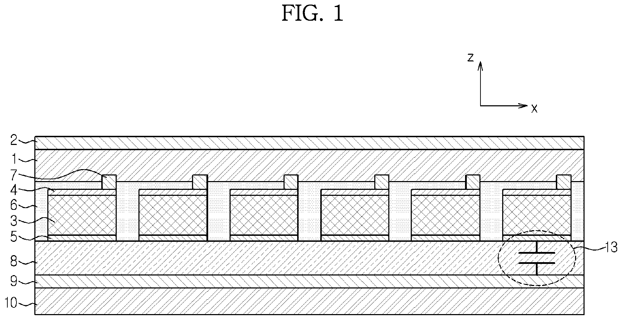

FIG. 1 is a schematic cross-sectional view in the z-x plane showing a radiation detector according to one embodiment of the present invention.

The radiation detector according to one embodiment of the present invention includes, a scintillator 1 formed on an incident surface where radiation incidence occurs, a plurality of photosensors 3 formed on the rear surface of the scintillator 1, a protective layer 6, which is an insulating material, formed to surround the photosensors 3, a plurality of signal electrodes 7 formed on the front surface of the photosensors 3, an insulation layer 8 formed on the rear surface of the photosensors 3, a plurality of data electrodes 9 formed on the rear surface of the insulation layer 8, and a substrate 10 having the data electrodes 9 formed thereon.

The scintillator 1 may be formed in the forward direction (+z-axis direction) of the detector to allow x-rays, which have passed through a subject body, to be incident thereon and absorbed therein.

The scintillator 1 may convert the absorbed x-rays into an optical wavelength, namely visible light in the green wavelength range, which in turn may be absorbed at the photosensors 3 of the detector.

The scintillator 1 may be made of a halogen compound such as cesium iodide doped with thallium or sodium or may include an oxide compound such as gadolinium sulfur oxide. However, embodiments of the present invention are not limited thereto.

Further, the scintillator 1 may include a photo-reflective layer 2 formed on the front surface of the scintillator 1 upon which the x-rays are incident. The reflective layer 2 may be made of a material which allows penetration of x-rays. For example, the reflective layer 2 may be made of a metal such as aluminum or titanium, or an organic material such as glass, carbon, or ceramic. However, embodiments of the present invention are not limited thereto.

The reflective layer 2 may improve radiation use efficiency by reflecting lost visible light among the converted visible light that have been emitted from the scintillator 1, back into the scintillator 1. The scintillator 1 may be adhered to the front surface of the photosensor 3 as a thin film, or deposited thereon by chemical vapor deposition (CVD).

The photosensors 3 may be formed on the rear surface of the scintillator 1, where the visible light that has been converted by passing through the scintillator 1, is absorbed and converted into an electrical signal.

The photosensors 3 may each have a front electrode 4 and a rear electrode 5 formed on the front and rear surfaces of the photosensors 3, respectively. The front electrode 4 contacts the signal electrode 7 which applies voltage to the photosensor 3, and the rear electrode 5 contacts the insulation layer 8.

The front electrode 4 may be made of a transparent conductive material so as to allow penetration of light absorbed from the outside. For example, the front electrode 4 may be made of indium tin oxide (ITO) or indium zinc oxide (IZO). However, embodiments of the present invention are not limited thereto.

The photosensor 3 may be made of a semiconductor material such as silicone.

Particularly, the photosensor 3 may be a PIN photodiode having a so-called PIN structure, which includes a P(positive)-type semiconductor layer, an I(intrinsic)-type semiconductor layer, and an N(negative)-type semiconductor layer, or a PN photodiode having a so-called PN structure, which includes a P(positive)-type semiconductor layer, and an N(negative)-type semiconductor layer. The this exemplary emobidment the us of PIN photodiode is described.

For example, in the case of the PIN photodiode, visible light passes through the P-type amorphous silicon layer and is absorbed by the I-type amorphous silicon layer. The absorbed visible light has greater energy than an optical band gap of the amorphous silicon in the I-type amorphous silicon layer, resulting in production of electrons and holes. The electrons and holes generated in the I-type amorphous silicon layer may be collected at the P-type and N-type silicon layers by an internal electric field. Finally, the electrons and holes are supplied to the external circuit through electrodes.

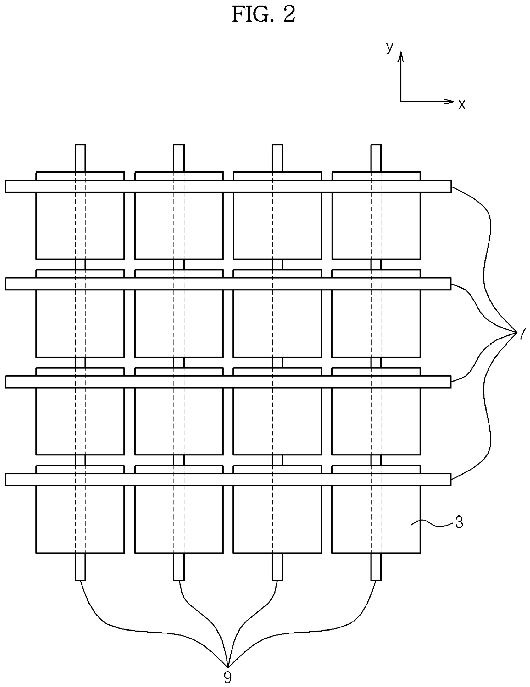

The photosensors 3 are provided in the ratio of one per pixel, and may be arranged in a two-dimensional array as a matrix to form an X-ray detector as shown in FIG. 2. For example, the photosensors 3 may be arranged as a square matrix having four rows and four columns (see FIG. 2).

The photosensor 3 may be covered/surrounded with the protective layer 6 which is an insulating material. The protective layer 6 may be made of an inorganic insulating material such as silicon oxide, silicon nitride, or silicon oxynitride, or an organic insulating material such as benzocyclobutene or polyamide.

The signal electrode 7 is formed on the front surface of the front electrode 4 of the photosensor 3 for electrical contact. The signal electrode 7 may receive reverse and forward bias voltage from an external power supply (not shown).

As shown in FIG. 2, a plurality of signal electrodes 7 in the form of lines may be respectively disposed on each row (x-axis direction) of the photosensors 3 arranged in a two-dimensional array as a matrix. For example, the signal electrodes 7 in the form of lines are respectively disposed on each row of the photosensors 3 arranged as a matrix having four rows and four columns. As a result, voltage may be applied to each row of the photosensors 3. That is, when voltage is applied to one row of the signal electrode 7, the voltage is applied to all the photosensors 3 disposed on the row, and the voltage is not applied to the other photosensors 3.

The signal electrode 7 may be made of a metal such as aluminum, molybdenum, chrome, neodymium, tantalum, titanium, tungsten, copper, or silver, alone or an alloy thereof. However, embodiments of the present invention are not limited thereto.

The insulation layer 8 is formed on the rear surface of the photosensor 3. The insulation layer 8 together with the rear electrode 5 of the photosensor 3 and the data electrode 9 to be described in the following form a capacitor 13. The detailed descriptions of the capacitor 13 will be illustrated with the description of the data electrode 9.

The data electrode 9 may be formed between the front (top) surface of the substrate 10 and the rear (bottom) surface of the insulation layer 8.

As shown in FIG. 2, a plurality of data electrodes 9 in the form of lines may be respectively disposed on each column (y-axis direction) of the photosensors 3 arranged in a two-dimensional array as a matrix. That is, the above-described signal electrodes 7 and the data electrodes 9 may be arranged to cross each other. That is, the signal electrodes 7 and the data electrodes 9 may be arranged substantially perpendicular to each other.

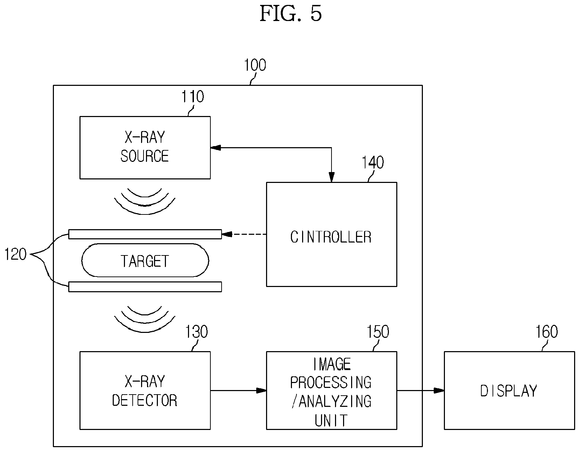

For example, as shown in FIG. 2, the data electrodes 9 in the form of lines are respectively disposed on each column of the photosensors 3 arranged as a matrix having four rows and four columns. As a result, the data electrodes 9 may have induced thereon an electrical signal in response to an electrical signal generated from the photosensor 3. The data electrodes 9 may be connected to a read out IC (ROIC) where the electrical signal from the data electrodes 9 is detected and a corresponding image signal is output to further processing and display units, as well known (see FIG. 5), to generate and display various types of images of the target.

As described in conjunction with the insulation layer 8, the data electrodes 9 together with the insulation layer 8 formed on the front surface of the data electrodes 9 and the rear electrodes of the photosensors 3 form the capacitor 13. The converted visible light passing through the scintillator 1 is absorbed into the photosensors 3 where the visible light is converted into the electrical signal. When a reverse bias voltage is applied to the signal electrodes 7, electrons are accumulated at the rear electrodes 5 of the photosensors 3. Since a degree of penetration of an x-ray differs according to a density of a subject body, the size of the electrical signal also differs accordingly. Therefore, a quantity of electric charge accumulated at the rear electrodes 5 also changes. When a forward bias voltage is applied to the signal electrodes 7 while having the electrons accumulated at the capacitor 13, the data electrodes 9, which form the other electrode of the capacitor 13, are induced with a charge in response to the quantity of accumulated charge at the rear electrodes 5 of the photosensors 3, thereby transferring the electrical signal to the data electrodes 9. The read out IC ROIC detects the electrical signal induced to data electrodes 9, and outputs a corresponding image signal. As described in conjunction with FIG. 2, the capacitor 13 may be formed by forming the plurality of data electrodes 9 on the substrate 10 in a column direction (y-axis direction) as a matrix, forming the insulation layer 8, made of an insulating material, on a front surface of the plurality of data electrodes 9, and forming the plurality of photosensors 3 formed with the front and rear electrodes 4 and 5 on the front surface of the insulation layer 8.

The substrate 10 is provided as a base for manufacturing the radiation detector. The substrate 10 may be in a form of plate. The substrate 10 may be made of a transparent insulating material such as glass, quartz, or plastic.

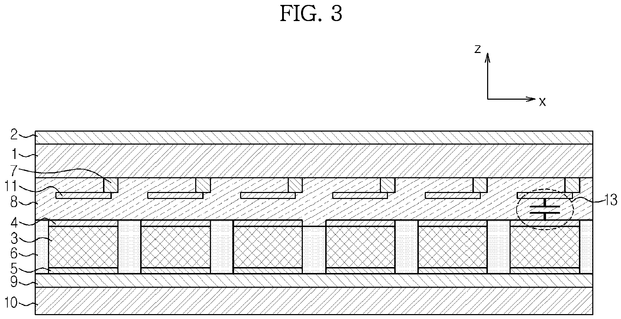

FIG. 3 is a schematic cross-sectional view showing a radiation detector according to another embodiment of the present invention.

The radiation detector according to another embodiment of the present invention includes, a scintillator 1 formed on an incident surface where radiation incidence occurs, an insulation layer 8 formed on the rear surface of the scintillator 1, a plurality of capacitor electrodes 11 covered with the insulation layer 8, a plurality of signal electrodes 7 formed on the front surface of the capacitor electrodes 11, a plurality of photosensors 3 formed on the rear surface of the insulation layer 8, a protective layer 6, which is an insulating material, formed to surround the photosensors 3, a plurality of data electrodes 9 formed on the rear surface of the photosensors 3, and a substrate 10 having the data electrodes 9 formed thereon.

Descriptions regarding the scintillator 1 are the same as the respective components in FIG. 1, thus additional descriptions thereof will be omitted.

The insulation layer 8 formed on the rear surface of the scintillator 1 together with the capacitor electrode 11 to be described in the following which is buried in the insulation layer 8 and the front electrode 4 of the photosensor 3, form a capacitor 13. The detailed descriptions of the capacitor 13 will be illustrated with the descriptions of the capacitor electrode 11. The insulation layer 8 may be made of a transparent insulating material such as glass, quartz, or plastic, in order to pass visible light that has been converted from x-rays by passing through the scintillator 1. The capacitor electrode 11 may be made of a transparent conductive material such as indium tin oxide (ITO) or indium zinc oxide (IZO). However, embodiments of the present invention are not limited thereto.

The capacitor electrode 11 together with the insulation layer 8 and the front electrode 4 of the photosensor 3 form the capacitor 13. The converted visible light by passing through the scintillator 1 is absorbed into the photosensors 3 where the visible light is converted into an electrical signal. When a reverse bias voltage is applied to the signal electrodes 7, electrons are accumulated at the front electrodes 4 of the photosensors 3. Since a degree of penetration of x-rays differs according to a density of a subject body, the size of the electrical signal also differs accordingly. Therefore, a quantity of electric charge accumulated at the front electrodes 4 also changes. When a forward bias voltage is applied to the signal electrodes 7 while having the electrons accumulated at the capacitor 13, the electrons accumulated at the front electrodes 4 of the photosensors 3 are transferred to the data electrodes 9 via the rear electrodes 5. The read out IC ROIC detects the electrical signal transferred to the data electrodes 9, and outputs a corresponding image signal. As described in conjunction with FIG. 2, the capacitor 13 may be formed by forming the plurality of data electrodes 9 on the substrate 10 in a column direction (y-axis direction) as a matrix, forming the plurality of photosensors 3 formed with the front and rear electrodes 4 and 5 on the front surface of the data electrodes 9, and forming the insulation layer 8, made of an insulating material on a front surface of photosensors 3, and forming the capacitor electrodes 11 buried in the insulation layer 8.

The signal electrodes 7 are formed on the front surface of the capacitor electrode 11 for electrical contact. The signal electrodes 7 may receive reverse and forward bias voltage from an external power supply (not shown).

As shown in FIG. 2, a plurality of signal electrodes 7 in the form of lines may be respectively disposed on each row (in the x-axis direction) of the photosensors 3 arranged in a two-dimensional array as a matrix. For example, the signal electrodes 7 in form of lines are respectively disposed on each row of the photosensors 3 arranged as a matrix having four rows and four columns. As a result, voltage may be applied to each row of the photosensors 3. That is, when voltage is applied to one row of the signal electrodes 7, the voltage is applied to all the capacitor electrodes 11 I disposed on the row, and the voltage is not applied to the other capacitor electrodes 11. The signal electrode 7 may be made of a metal such as aluminum, molybdenum, chrome, neodymium, tantalum, titanium, tungsten, copper, or silver, alone or an alloy thereof. However, embodiments of the present invention are not limited thereto.

Referring again to FIG. 3, the photosensor 3 is formed on the rear surface of the insulation layer 8, where the visible light that has been converted by passing through the scintillator 1, is absorbed and converted into an electrical signal.

The photosensor 3 may have a front electrode 4 and a rear electrode 5 formed on the front and rear surfaces of the photosensor 3, respectively. The front electrode 4 contacts the insulation layer 8 and the rear electrode 5 contacts the data electrode 9. The front electrode 4 may be made of a transparent conductive material so as to allow penetration of light absorbed from the outside. For example, the front electrode 4 may be made of indium tin oxide (ITO) or indium zinc oxide (IZO). However, embodiments of the present invention are not limited thereto. Descriptions on the photosensors 3 are the same as the respective components in FIG. 1, thus additional descriptions thereof will be omitted.

The photosensor 3 may be surrounded with the protective layer 6 which is an insulating material. The protective layer 6 may be made of an inorganic insulation material such as silicon oxide, silicon nitride, or silicon oxynitride, or an organic insulation material such as benzocyclobutene or polyamide.

The data electrode 9 may be formed between the front surface of the substrate 10 and the rear surface of the photosensors 3.

As shown in FIG. 2, a plurality of data electrodes 9 in the form of lines may be respectively disposed on each column of the photosensors 3 arranged in a two-dimensional array as a matrix. The above-described signal electrodes 7 and the data electrodes 9 may be arranged to cross each other. That is, the signal electrodes 7 and the data electrodes 9 may be arranged substantially perpendicular to each other.

For example, as shown in FIG. 2, the data electrodes 9 in the form of lines are respectively disposed on each column of the photosensors 3 arranged as a matrix having four rows and four columns. As a result, the data electrodes 9 may directly receive an electrical signal generated from the photosensor 3. The data electrodes 9 may be connected to a read out IC (ROIC) where the electrical signal from the data electrodes 9 is detected and a corresponding image signal is output.

Descriptions regarding the substrate 10 are the same as the respective components in FIG. 1, thus additional descriptions thereof will be omitted.

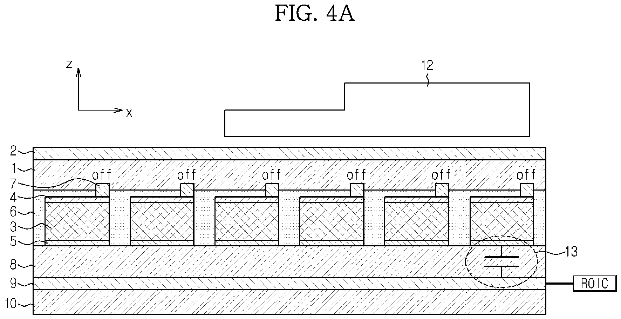

FIGS. 4A through 4C are schematic views which illustrate the operation of a radiation detector according to one embodiment of the present invention, such as the detector shown in FIG. 1.

FIG. 4A illustrates a detector before having x-rays applied to a subject body (target) 12. Here, signal electrodes 7 are applied with a reverse bias voltage (for example, -5v) to maintain an off-state. As described above, a data electrode 9, an insulation layer 8, and a rear electrode 5 of a photosensor 3 form a capacitor 13.

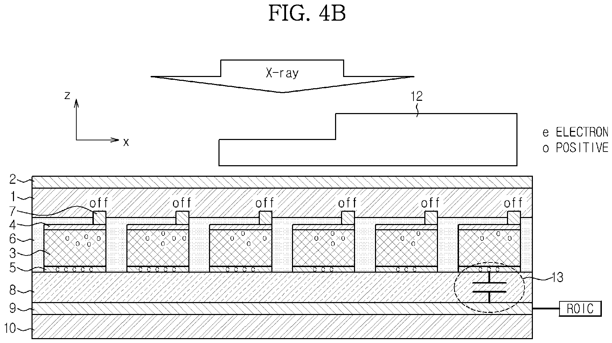

When x-rays incident on the subject body 12 penetrate the subject body 12, the strength of the x-rays becomes attenuated by a density of the subject body 12 (in FIGS. 4A through 4C, a difference in the density is shown as a difference in thickness of the subject body 12) of the subject body 12, which attenuated X-rays become incident to/are applied to a scintillator 1 of the detector (see FIG. 4B). As described above, the x-rays applied to the scintillator 1 is converted into visible light which is then applied to the photosensors 3. The photosensors 3 absorbs the visible light, and convert the light energy into an electrical signal. The electrical signal is accumulated on the rear electrodes 5 of the photosensors 3. The data electrodes 9 are induced with opposite charges in response to the accumulated charges on the rear electrodes 5. As a result, the capacitor 13 formed including the rear electrode 5, the insulation layer 8, and the data electrode 9 is charged with charges. There is a size difference in an electrical signal generated from the photosensors 3 in a region to which the x-rays having passed through the subject body 12 are applied and from the photosensors 3 in a region to which the x-rays not having passed through the subject body 12 are applied. For example, the two left-most respective photosensors 3 present in the region where the x-rays are directly applied, that is, without having passed through body 12, have a greater electrical signal than that of the third and fourth photosensors 3 from the left (which present in the region where attenuated x-rays pass through a lower density portion of the subject body 12). Also, the third and fourth photosensors 3 from the left have a greater electrical signal than that generated from the remaining twoe respective photosensors 3 which present in the region where attenuated x-rays pass through the highest density portion of the subject body 12. In FIGS. 4B through 4C, such a difference corresponds to a difference in the number of electrons accumulated on each rear electrode 5.

After the capacitor 13 has been charged with charges, a forward bias voltage is applied in an orderly manner to each signal electrode 7 in a form of line formed on respective row of the photosensors 3 arranged to cross each other. When the signal electrodes 7 are turned on, voltage applied to the data electrodes 9 of the capacitor 13 changes in response thereto. As a result, charges are transferred in accordance with the changes in the voltage.

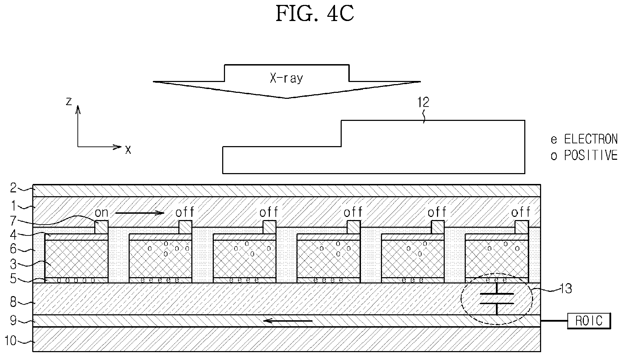

For example, when the signal electrodes 7 in an off-state (for example, applied with a reverse bias voltage of -5v) are applied with a forward bias voltage of +5v to change the signal electrodes 7 to an on-state, each rear electrode 5 of the photosensors 3 generates holes, while electrons in response to the voltage change are generated at the other electrode, i.e. the data electrode, forming the capacitor 13. As shown in FIG. 4C, when the signal electrodes 7 are turned on orderly from the left to right the charges are transferred to the left. The read out IC ROIC connected with the data electrodes 9 detects movement of the charges generated in the data electrodes 9 (as shown by the directional arrow in electrode 9) and outputs an image signal.

FIG. 5 illustrates the basic components of a typical X-ray image generating system 100, modified, however, so as to incorporate an X-ray detector constructed and operated according to one or more of the embodiments described above.

Referring to FIG. 5, as only an example, the X-ray image generating system 100 may include an X-ray source 110, an X-ray detector 130, a controller 140, and an image processing/analyzing unit 150. A stage 120 may be a device designed to selectively immobilize a target by applying a predetermined amount of pressure to the target or by removing the applied pressure from the target.

In differing embodiments, a display 160 is included in or separate from the image processing system 100. In addition, in one or more embodiment, any of the controller 140, X-ray detector 130, image processing/analyzing unit 150, or display 160 may also include a memory for storing and later recall of any detected target images, optimal images, or hard and soft tissue images generated by image generating system 100. In one or more embodiments, the image processing/analyzing unit 150 is further configured to control the display of any detected target images, optimal images, or hard and soft tissue images by display 160.

The method of making and operating each of these components, other than the detector 130 already described herein, are well known to those of ordinary skill in the art, so in the interest of clarity, only a basic description is given herein.

The X-ray source 110 may radiate X-rays toward a target (object to be imaged) illustrated in FIG. 5, such that the X-rays radiate through the target toward the X-ray detector 130. The X-rays passing through the target may be detected by the X-ray detector 130. A dose and voltage of the X-rays radiated from the X-ray source 110, and a radiation time may be controlled by the control unit 140, as well known by those of ordinary skill in the art.

The X-ray detector 130 may acquire a plurality of target images that are formed by passing X-rays from the X-ray source 110, through the target, thereby acquiring the plurality of target images.

The controller 140 may control the X-ray source 110 so that an X-ray may be radiated to the target in a predetermined dose/voltage within or during a predetermined time period. Additionally, at any time during the process, the controller 140 may control the stage 120 to adjust the pressure applied to the target.

The image processing/analyzing unit 150 may perform image processing on the target images acquired by the X-ray detector 130 during the predetermined time interval. Any one of several well known image processing schemes can then be used to create and display one or more images based on the target images acquired by the X-ray detector 130.

Although a few embodiments of the present invention have been shown and described, it would be appreciated by those skilled in the art that changes may be made in these embodiments without departing from the principles and spirit of the invention, the scope of which is defined in the claims and their equivalents.

## Claims

1. A radiation detector **CHARACTERIZED BY**:
a plurality of photosensors (3) having front (4) and rear (5) electrodes formed on front and rear surfaces thereof;
an insulation layer (8) formed on the rear surface of the photosensors;
a plurality of data electrodes (9) formed on the rear surface of the insulation layer;
a plurality of signal electrodes (7) formed on the front surface of the photosensors; and
a capacitor (13)comprising the rear electrode (5) formed on the rear surface of the photosensor, the insulation layer (8) formed on the rear surface of the rear electrode, and the data electrode (9) formed on the rear surface of the insulation layer.

2. The radiation detector according to claim 1, wherein the data electrode induces an electrical signal in response to an electrical signal generated from the photosensor, the signal electrode applies a voltage to the plurality of photosensors, and the signal electrode and the data electrode are arranged substantially perpendicular to each other.

3. The radiation detector according to claim 1, wherein the front electrode of the photosensor is a transparent electrode made of any one of indium tin oxide (ITO) or indium zinc oxide (IZO).

4. The radiation detector according to claim 1, wherein the photosensor is any one of a PIN photodiode or a PN photodiode.

5. The radiation detector according to claim 1, further comprising a scintillator (1) formed on the front surface of the front electrode of the photosensor, said scintillator converting radiation applied to the radiation detector into visible light.

6. The radiation detector according to claim 1, further comprising a protective layer (6), which is an insulating layer, formed so as to surround the photosensor, wherein the protective layer is made of a material selected from a group including silicon oxide, silicon nitride, silicon oxynitride, benzocyclobutene, and polyamide.

7. A radiation detector **CHARACTERIZED BY**:
a plurality of photosensors (3) having front (4) and rear (5) electrodes formed on front and rear surfaces thereof;
a plurality of data electrodes (9) formed on the rear surface of the photosensors;
an insulation layer (8) formed on the front surface of the photosensors;
a plurality of capacitor electrodes (11) formed on the front surface of the insulation layer;
a plurality of signal electrodes (7) formed on the front surface of the plurality of capacitor electrodes; and
a capacitor comprising the front electrode (4) formed on the front surface of the photosensor, the insulation layer (8) formed on the front surface of the front electrode, and the capacitor electrode (11) formed on the front surface of the insulation layer.

8. The radiation detector according to claim 7, wherein the data electrode receives an electrical signal generated from the photosensor, the signal electrode applies a voltage to the plurality of capacitor electrodes, and the signal electrode and the data electrode are arranged substantially perpendicular to each other.

9. The radiation detector according to claim 7, wherein the front electrode of the photosensor is a transparent electrode made of any one selected from indium tin oxide (ITO) or indium zinc oxide (IZO), and the photosensor is any one of a PIN photodiode or a PN photodiode.

10. The radiation detector according to claim 7, further comprising a scintillator formed on the front surface of the capacitor electrode and which converts radiation applied to the radiation detector into visible light.

11. The radiation detector according to claim 7, further comprising a protective layer, which is an insulating layer, formed so as to surround the photosensor, wherein the protective layer is made of a material selected from a group including silicon oxide, silicon nitride, silicon oxynitride, benzocyclobutene, and polyamide.

12. A method for manufacturing a radiation detector **CHARACTERIZED BY**:
forming a plurality of data electrodes (9) on a substrate;
forming an insulation layer (8) on the front surface of the data electrode;
forming a plurality of photosensors (3) having front and rear electrodes (4/5) formed on front and rear surfaces thereof on the front surface of the insulation layer; and
forming a capacitor (13) comprising the rear [THIS SEEMS TO HAVE BEEN AN ERROR. CLAIM DIRECTED TO FIG 1, AND THEREFORE SHOULD SAY "REAR", NOT "FRONT"] electrode, the insulation layer, and the data electrode.

13. A method for manufacturing a radiation detector **CHARACTERIZED BY**:
forming a plurality of data electrodes on a substrate;
forming a plurality of photosensors having front and rear electrodes formed on front and rear surfaces thereof on the front surface of the data electrode;
forming an insulation layer on the front surface of the photosensor;
forming a plurality of capacitor electrodes on the front surface of the insulation layer; and
forming a capacitor comprising the capacitor electrode, the insulation layer, and the front electrode.
[ADDITION OF "SYSTEM" CLAIMS WHICH USE THE NEW DETECTOR OF FIG 1 & FIG 3 (CORRESPONDING TO CLAIMS 1 & 11]

14. An X-ray imaging system, the system comprising:
an X-ray source unit for radiating a plurality of X-rays within a repeating predetermined period of time under control of a controller;
an X-ray detector for detecting X-rays radiated by the X-ray source unit after the X-rays have passed through a target, said X-ray detector generating at least one target image in response to said detecting; and
an image processing/analyzing unit for generating at least one tissue image, where the detector comprises: a plurality of photosensors having front and rear electrodes formed on front and rear surfaces thereof; an insulation layer formed on the rear surface of the photosensors; a plurality of data electrodes formed on the rear surface of the insulation layer; a plurality of signal electrodes formed on the front surface of the photosensors; and a capacitor comprising the rear electrode formed on the rear surface of the photosensor, the insulation layer formed on the rear surface of the rear electrode, and the data electrode formed on the rear surface of the insulation layer.

15. An X-ray imaging system, comprising:
X-ray source unit for radiating a plurality of X-rays within a repeating predetermined period of time, under control of a controller;
an X-ray detector for detecting X-rays radiated by the X-ray source unit after the X-rays have passed through a target, said X-ray detector generating at least one target image in response to said detecting; and
an image processing/analyzing unit for generating at least one tissue image, where the detector comprises: a plurality of photosensors having front and rear electrodes formed on front and rear surfaces thereof; a plurality of data electrodes formed on the rear surface of the photosensors; an insulation layer formed on the front surface of the photosensors; a plurality of capacitor electrodes formed on the front surface of the insulation layer; a plurality of signal electrodes formed on the front surface of the plurality of capacitor electrodes; and a capacitor comprising the front electrode formed on the front surface of the photosensor, the insulation layer formed on the front surface of the front electrode, and the capacitor electrode formed on the front surface of the insulation layer.
